# EUROPEAN PATENT APPLICATION

(11) **EP 4 835 370 A1**
(43) Date of publication of application: **04.11.2026**
(21) Application number: 26152109.0
(22) Date of filing: 15.01.2026
(51) Int. Cl.: F25B 9/10, F25B 49/00, G01R 33/3815, H01F 6/04

(54) **SUPERCONDUCTING MAGNET DEVICE AND CONTROL DEVICE FOR SUPERCONDUCTING MAGNET DEVICE**

(30) Priority: 30.04.2025 JP 2025075734
(71) Applicant: Sumitomo Heavy Industries, Ltd., Tokyo 141-6025 (JP)
(72) Inventor: OOTANI, Yuuki, Tokyo, 188-8585, (JP)
(74) Representative: Louis Pöhlau Lohrentz

(57) **Abstract**

Provided is a diagnostic technique for a cryocooler in a superconducting magnet device.

A superconducting magnet device (100) includes a superconducting coil device (110) that is operable in a plurality of operation modes, a cryocooler (10) that cools the superconducting coil device (110), a controller (140) that is configured to operate the superconducting coil device (110) in a selected operation mode among the plurality of operation modes and is configured to determine an operating parameter of the cryocooler (10) based on a comparison of a cooling temperature of the superconducting coil device (110) or the cryocooler (10) with a temperature target value and to operate the cryocooler (10) by using the determined operating parameter, and a cryocooler monitor (142) that is configured to acquire a value of the determined operating parameter when the superconducting coil device (110) is operating in the selected operation mode, and to diagnose the cryocooler (10) based on the acquired value of the operating parameter.

## Description

### BACKGROUND OF THE INVENTION

### Field of the Invention

The present invention relates to a superconducting magnet device and a control device for a superconducting magnet device.

### Description of Related Art

In the related art, a superconducting magnet device cooled by a cryocooler with inverter control is known for energy saving (for example, Patent Document 1). In the superconducting magnet device, in a case where the measured temperature of the superconducting magnet device is higher than the set temperature when the device is started up and is cooled from an environmental temperature (for example, room temperature) to a cryogenic set temperature (for example, 10 K), the cooling capacity of the cryocooler is increased by increasing the output frequency of the inverter. On the other hand, in a case where the measured temperature of the superconducting magnet device is lower than the set temperature, the cooling capacity of the cryocooler is reduced by decreasing the output frequency of the inverter.

[Patent Document 1] Japanese Unexamined Patent Publication No. 2000-121192

### SUMMARY OF THE INVENTION

As a result of intensive studies on the superconducting magnet device, the present inventor has come to recognize the following problems. Since the cooling unit is lost in a case where the cryocooler fails in the superconducting magnet device, the operation of the superconducting magnet device is inevitably stopped. Since the superconducting magnet device has a large heat capacity, once the temperature is raised, it takes a considerable amount of time to cool down again. In particular, in a case of a sudden failure, for example, it takes time to arrange a repair service for the cryocooler, and the time taken to restore the superconducting magnet device is likely to be longer, which is not desirable.

However, in a case where the failure or a precursor of the failure of the cryocooler is identified and can be proactively dealt with in advance, the influence on the operation of the superconducting magnet device can be minimized. As a typical measure, the performance reduction of the cryocooler over time can be identified by monitoring the cooling temperature of the cryocooler. However, this method is not necessarily effective for the inverter-equipped cryocooler as described above. This is because, even in a case where the cooling performance of the cryocooler is reduced, such performance reduction is compensated to some extent by the increase in the output frequency of the inverter and the cooling temperature is less likely to be affected.

One exemplary object of one aspect of the present invention is to provide a diagnostic technique for a cryocooler in a superconducting magnet device.

According to an embodiment of the present invention, a superconducting magnet device includes a superconducting coil device that is operable in a plurality of operation modes, a cryocooler that cools the superconducting coil device, a controller that is configured to operate the superconducting coil device in a selected operation mode among the plurality of operation modes and is configured to determine an operating parameter of the cryocooler based on a comparison of a cooling temperature of the superconducting coil device or the cryocooler with a temperature target value and to operate the cryocooler by using the determined operating parameter, and a cryocooler monitor that is configured to acquire a value of the determined operating parameter when the superconducting coil device is operating in the selected operation mode, and to diagnose the cryocooler based on the acquired value of the operating parameter.

According to another embodiment of the present invention, there is provided a control device of a superconducting magnet device. The superconducting magnet device includes a superconducting coil device that is operable in a plurality of operation modes and a cryocooler that cools the superconducting coil device. The control device includes a controller that is configured to operate the superconducting coil device in a selected operation mode among the plurality of operation modes and is configured to determine an operating parameter of the cryocooler based on a comparison of a cooling temperature of the superconducting coil device or the cryocooler with a temperature target value and to operate the cryocooler by using the determined operating parameter, and a cryocooler monitor that is configured to acquire a value of the determined operating parameter when the superconducting coil device is operating in the selected operation mode, and to diagnose the cryocooler based on the acquired value of the operating parameter.

It is noted that any combination of the components described above, or replacement of components or expressions of the present invention with each other between methods, apparatuses, systems, computer programs, a recording medium, or the like is also effective as an aspect of the present invention.

### [Effect of the invention]

According to the present invention, a diagnostic technique for a cryocooler in a superconducting magnet device can be provided.

### BRIEF DESCRIPTION OF THE DRAWINGS

FIG. 1 is a diagram schematically showing a superconducting magnet device according to an embodiment.
FIG. 2 is a diagram schematically showing a cryocooler that may be mounted in the superconducting magnet device shown in FIG. 1.
FIG. 3 is a diagram schematically showing the cryocooler that may be mounted in the superconducting magnet device shown in FIG. 1.
FIG. 4 is a graph schematically showing an exemplary operation of the superconducting magnet device according to the embodiment.
FIG. 5 is a flowchart showing an example of a diagnostic method for a cryocooler according to the embodiment.
FIG. 6 is a graph schematically showing a history of an operating parameter of a cryocooler used for diagnosing the cryocooler according to the embodiment.
FIG. 7 is a graph schematically showing statistical analysis of operation history data of a superconducting magnet device used for diagnosing the cryocooler according to the embodiment.

### DETAILED DESCRIPTION OF THE INVENTION

Hereinafter, an embodiment for carrying out the present invention will be described in detail with reference to the drawings. In the description and the drawings, the same or equivalent components, members, and processes will be denoted by the same reference numerals, and overlapping descriptions will be omitted as appropriate. The scale or shape of each part that is shown in the drawings is conveniently set for ease of description and is not limitedly interpreted unless otherwise specified. The embodiment is merely an example and does not limit the scope of the present invention in any way. All of the features described in the embodiments and combinations thereof are not necessarily essential to the invention.

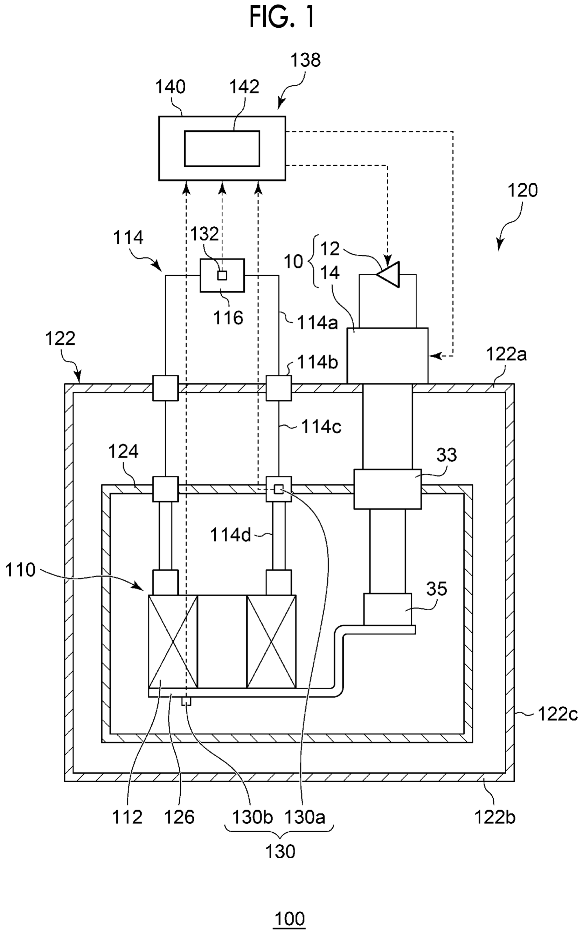

FIG. 1 is a diagram schematically showing a superconducting magnet device 100 according to the embodiment. The superconducting magnet device 100 can be mounted on a high-magnetic field utilization device as a magnetic field source of, for example, a single crystal pulling device, a nuclear magnetic resonance (NMR) system, a magnetic resonance imaging (MRI) system, an accelerator such as a cyclotron, a high energy physical system such as a nuclear fusion system, or other high-magnetic field utilization devices (not shown), and can generate a high magnetic field required for the device.

The superconducting magnet device 100 includes a superconducting coil device 110, a cryogenic device 120, at least one temperature sensor 130, a state monitoring sensor 132, and a control device 138. The superconducting coil device 110 includes a superconducting coil 112, an electric current introduction line 114, and an excitation power supply 116. The cryogenic device 120 includes a vacuum chamber 122, a cryocooler 10, and a thermal shield 124. The control device 138 of the superconducting magnet device 100 includes a controller 140 that controls the superconducting coil device 110 and the cryocooler 10, and a cryocooler monitor 142 that diagnoses the cryocooler 10.

The superconducting coil 112 is disposed in the vacuum chamber 122. The superconducting coil 112 is thermally coupled to the cryocooler 10 installed in the vacuum chamber 122 and is used in a state cooled to a cryogenic temperature equal to or lower than a critical temperature. The superconducting coil 112 is configured to generate a strong magnetic field by being energized in a state cooled in this manner. The superconducting coil 112 may be a known superconducting coil (for example, a so-called low-temperature superconducting coil).

The vacuum chamber 122 is an adiabatic vacuum chamber that provides a cryogenic vacuum environment suitable for bringing the superconducting coil 112 into a superconducting state, and is also called a cryostat. Typically, the vacuum chamber 122 has a columnar shape or a cylindrical shape with a hollow portion in a central portion thereof. Therefore, the vacuum chamber 122 includes a substantially flat circular or annular top plate 122a and bottom plate 122b, and a cylindrical side wall (cylindrical outer peripheral wall, or coaxially disposed cylindrical outer peripheral wall and inner peripheral wall) 122c connecting the top plate 122a and the bottom plate 122b. The cryocooler 10 may be installed on the top plate 14a of the vacuum chamber 122. The vacuum chamber 122 is formed of, for example, a metal material such as stainless steel or other suitable high-strength materials to withstand an ambient pressure (for example, atmospheric pressure).

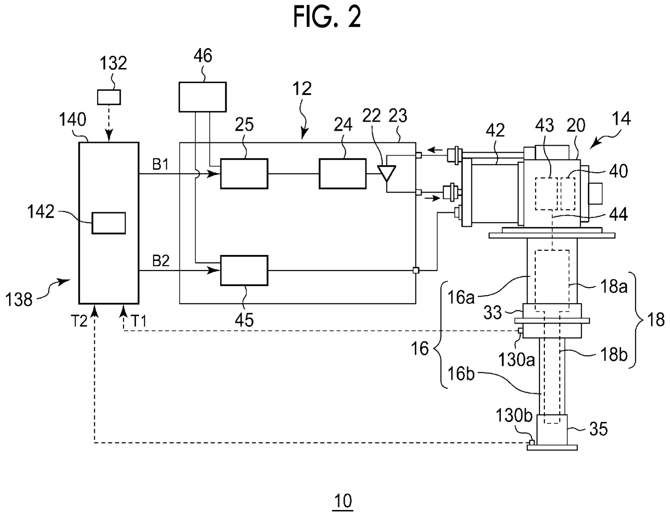

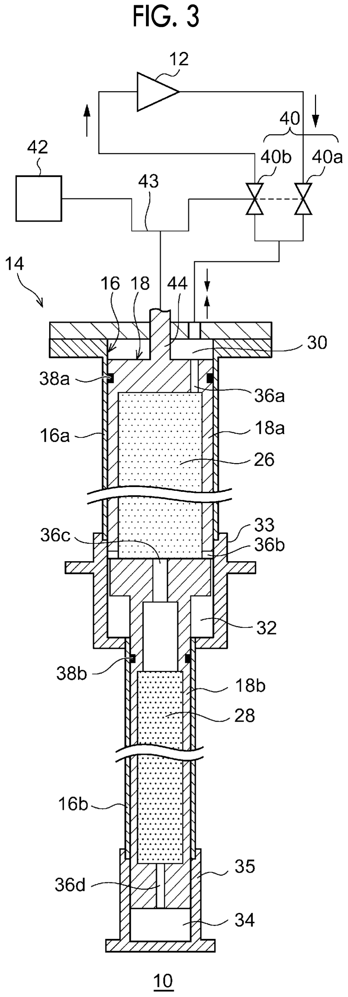

The cryocooler 10 is configured to cool the thermal shield 124 to a first cooling temperature and to cool the superconducting coil 112 to a second cooling temperature lower than the first cooling temperature. In this embodiment, the cryocooler 10 is a two-stage cryocooler and includes a first cooling stage 33 and a second cooling stage 35. The first cooling temperature may be in a temperature range of about 20K to about 100K, for example, a temperature range of about 30K to about 50K, and the second cooling temperature may be in a temperature range of about 3K to about 20K, for example, about 4K. An exemplary configuration of the cryocooler 10 will be described below with reference to FIGS. 2 and 3.

In FIG. 1, one cryocooler 10 is shown as an example, but the superconducting magnet device 100 may include a plurality of cryocoolers 10 as necessary, for example, in a case where the superconducting coil 112 is large, and one superconducting coil 112 may be cooled by the plurality of cryocoolers 10.

The thermal shield 124 is disposed to surround the superconducting coil 112 within the vacuum chamber 122. The thermal shield 124 is formed of, for example, a metal material such as copper or other material having high thermal conductivity. The thermal shield 124 is directly attached to the first cooling stage 33 of the cryocooler 10 and is thermally coupled to the first cooling stage 33. Alternatively, the thermal shield 124 may be attached to the first cooling stage 33 via a heat transfer member having flexibility or stiffness. During the operation of the superconducting magnet device 100, the thermal shield 124 is cooled to a first cooling temperature by the first cooling stage 33. The thermal shield 124 can thermally protect low-temperature sections such as the second cooling stage 35 of the cryocooler 10 and the superconducting coil 112 which are disposed inside the thermal shield 124 and are cooled to a lower temperature than the thermal shield 124, from radiant heat from the vacuum chamber 122.

In this embodiment, the superconducting magnet device 100 is configured as a so-called conduction cooling type in which the superconducting coil 112 is directly cooled by the cryocooler 10. The superconducting coil 112 is thermally coupled to the second cooling stage 35 via a heat transfer member 126. The heat transfer member 126 is formed of, for example, a metal material such as copper or another material having a high thermal conductivity, and connects the superconducting coil 112 to the second cooling stage 35. The heat transfer member 126 may be a rigid member that rigidly connects the superconducting coil 112 and the second cooling stage 35, or may flexibly connect the superconducting coil 112 and the second cooling stage 35 to allow relative displacement between them. Alternatively, the superconducting coil 112 may be directly attached to the second cooling stage 35 and may be thermally coupled to the second cooling stage 35. During the operation of the superconducting magnet device 100, the superconducting coil 112 is cooled to the second cooling temperature by the second cooling stage 35.

It is noted that, in another embodiment, the superconducting magnet device 100 may be configured as an immersion cooling type in which the superconducting coil 112 is immersed in a cryogenic liquid refrigerant such as liquid helium. In this case, the cryocooler 10 is used for cooling, that is, recondensing of the liquid refrigerant. The cryocooler 10 can cool the superconducting coil 112 via the liquid refrigerant.

The superconducting coil 112 is connected to the excitation power supply 116 disposed outside the vacuum chamber 122 via the electric current introduction line 114. A current (hereinafter, also referred to as an excitation current) is supplied from the excitation power supply 116 to the superconducting coil 112 via the electric current introduction line 114. In this way, the superconducting magnet device 100 can generate a strong magnetic field.

The electric current introduction line 114 includes an external wiring line 114a, a feedthrough terminal 114b, an outer current lead 114c, and an inner current lead 114d, and forms a current path from the excitation power supply 116 to the superconducting coil 112. Typically, one electric current introduction line 114 on a positive electrode side and one electric current introduction line 114 on a negative electrode side are provided.

The external wiring line 114a disposed outside the vacuum chamber 122 connects the excitation power supply 116 to the feedthrough terminal 114b provided in a wall portion of the vacuum chamber 122. The external wiring line 114a may be an appropriate power supply cable. The feedthrough terminal 114b is airtight terminal for introducing a current into the vacuum chamber 122, and connects the external wiring line 114a to an internal wiring line (that is, the outer current lead 114c and the inner current lead 114d) in the vacuum chamber 122. The electric current introduction line 114 can penetrate the wall portion of the vacuum chamber 122 while maintaining the airtightness of the vacuum chamber 122 by the feedthrough terminal 114b.

The outer current lead 114c is disposed outside the thermal shield 124 in the vacuum chamber 122 and connects the feedthrough terminal 114b to the inner current lead 114d. The outer current lead 114c is formed of, for example, a metal material having excellent conductivity and represented by pure copper such as oxygen-free copper. A low-temperature side end portion of the outer current lead 114c connected to the inner current lead 114d is thermally coupled to the thermal shield 124. The low-temperature side end portion of the outer current lead 114c is fixed to the thermal shield 124 or is connected to the thermal shield 124 via an appropriate heat transfer member and is cooled to the first cooling temperature, like the thermal shield 124. However, the outer current lead 114c is in a state of being electrically insulated from the thermal shield 124. For example, the outer current lead 114c may be attached to a fixation portion, such as the thermal shield 124 or the heat transfer member, such that an insulating material (for example, a sheet of an insulating resin material) is interposed between the outer current lead 114c and the fixation portion.

The inner current lead 114d is disposed inside the thermal shield 124 and connects the outer current lead 114c to the superconducting coil 112. The inner current lead 114d may be, for example, a high-temperature superconducting current lead formed of a copper oxide superconductor or another high-temperature superconducting material. A high-temperature side end portion of the inner current lead 114d connected to the outer current lead 114c is thermally coupled to the thermal shield 124 and is cooled to the first cooling temperature, like the thermal shield 124. A low-temperature side end portion of the inner current lead 114d connected to the superconducting coil 112 is cooled to the second cooling temperature, like the superconducting coil 112.

FIGS. 2 and 3 are diagrams schematically showing the cryocooler 10 that may be mounted on the superconducting magnet device 100 shown in FIG. 1. FIG. 2 shows an external view of the cryocooler 10 together with a schematic block diagram, and FIG. 3 shows an internal structure of the cryocooler 10. The cryocooler 10 is, as an example, a two-stage type Gifford-McMahon (GM) cryocooler.

The cryocooler 10 includes a compressor 12 and an expander 14. The compressor 12 is configured to collect a working gas of the cryocooler 10 from the expander 14, to pressurize the collected working gas, and to supply the working gas to the expander 14 again. The working gas is also called a refrigerant gas, and is usually a helium gas. However, other suitable gases may be used.

It is noted that in general, both of the pressure of a working gas to be supplied from the compressor 12 to the expander 14 and the pressure of a working gas to be collected from the expander 14 to the compressor 12 are considerably higher than the atmospheric pressure, and can be called a first high pressure and a second high pressure, respectively. For convenience of description, the first high pressure and the second high pressure are simply called a high pressure and a low pressure, respectively. Typically, the high pressure is, for example, 2 to 3 MPa. The low pressure is, for example, 0.5 to 1.5 MPa, and is, for example, about 0.8 MPa. For better understanding, a direction in which the working gas flows is shown with arrows.

The compressor 12 includes a compressor main body 22 and a compressor casing 23 that accommodates the compressor main body 22. The compressor 12 will also be referred to as a compressor unit.

The compressor main body 22 is configured to compress, inside the compressor main body 22, the working gas sucked in through the suction port and to discharge the working gas through a discharge port. The compressor main body 22 may be, for example, a scroll type pump, a rotary type pump, or other pumps that pressurize the working gas. The compressor main body 22 may be configured to discharge the working gas at a fixed and constant flow rate. Alternatively, the compressor main body 22 may be configured to change the flow rate of the working gas to be discharged. The compressor main body 22 will be referred to as a compression capsule in some cases.

In addition, the compressor 12 includes a compressor motor 24 and a compressor inverter 25 that controls an operation frequency, that is, a rotation speed of the compressor motor 24. The compressor motor 24 is a drive source that drives the compressor main body 22, and is, for example, an electric motor that is driven by three-phase alternating current. The compressor inverter 25 is configured to convert an alternating current input from a power source 46 to the compressor inverter 25 into an alternating current having a frequency different from the input alternating current, and supply the converted alternating current to the compressor motor 24. The power source 46 may be an external power source such as a commercial power source (three-phase alternating current power source). The operation frequency of the compressor motor 24 may be controlled by the compressor inverter 25 in a range of 30 Hz to 100 Hz or in a range of 40 Hz to 70 Hz.

As is known, the compressor 12 may have various other components (not shown). For example, an oil separator, an adsorber, or the like may be provided in a working gas flow path on a discharge side. A storage tank or other components may be provided in the working gas flow path on a suction side. In addition, the compressor 12 may be provided with an oil circulation system that cools the compressor main body 22 with oil, a cooling system that cools the oil with cooling water, or the like.

The expander 14 includes an expander cylinder 16 and a displacer assembly 18. The expander cylinder 16 guides linear reciprocating motion of the displacer assembly 18 and forms expansion chambers (32 and 34) for the working gas between the expansion chamber 16 and the displacer assembly 18. In addition, the expander 14 includes a pressure switching valve 40 that determines a timing when the working gas to the expansion chambers starts to be sucked and a timing when the working gas from the expansion chambers starts to be discharged.

In the present specification, to describe a positional relationship between components of the cryocooler 10, for convenience of description, a side close to a top dead center of axial reciprocation of a displacer will be referred to as "up" and a side close to a bottom dead center will be referred to as "down". The top dead center is the position of the displacer at which the volume of an expansion space is maximum, and the bottom dead center is the position of the displacer at which the volume of the expansion space is minimum. Since a temperature gradient in which the temperature drops from an upper side to a lower side in an axial direction is generated during the operation of the cryocooler 10, the upper side can also be called a high temperature side and the lower side can also be called a low temperature side.

The expander cylinder 16 includes a first cylinder 16a and a second cylinder 16b. The first cylinder 16a and the second cylinder 16b each are, as an example, a member that has a cylindrical shape, and the second cylinder 16b has a diameter smaller than that of the first cylinder 16a. The first cylinder 16a and the second cylinder 16b are coaxially disposed, and a lower end of the first cylinder 16a is rigidly connected to an upper end of the second cylinder 16b.

The displacer assembly 18 includes a first displacer 18a and a second displacer 18b that are connected to each other, and the displacers move integrally. The first displacer 18a and the second displacer 18b each are, as an example, a member that has a cylindrical shape, and the second displacer 18b has a diameter smaller than that of the first displacer 18a. The first displacer 18a and the second displacer 18b are coaxially disposed.

The first displacer 18a is accommodated in the first cylinder 16a, and the second displacer 18b is accommodated in the second cylinder 16b. The first displacer 18a can reciprocate in an axial direction along the first cylinder 16a, and the second displacer 18b can reciprocate in the axial direction along the second cylinder 16b.

As shown in FIG. 3, the first displacer 18a accommodates a first regenerator 26. The first regenerator 26 is formed by filling a tubular main body of the first displacer 18a with, for example, a wire mesh made of, such as copper, or other appropriate first regenerator material. An upper lid portion and a lower lid portion of the first displacer 18a may be provided as separate members from the main body of the first displacer 18a, or the upper lid portion and the lower lid portion of the first displacer 18a may be fixed to the main body by any appropriate method such as fastening or welding, thereby accommodating the first regenerator material in the first displacer 18a.

Similarly, the second displacer 18b accommodates a second regenerator 28. The second regenerator 28 is formed by filling a tubular main body of the second displacer 18b, for example, with a non-magnetic regenerator material such as bismuth, a magnetic regenerator material such as HoCu₂, or other appropriate second regenerator materials. The second regenerator material may be molded into a granular shape. An upper lid portion and a lower lid portion of the second displacer 18b may be provided as members separate from the main body of the second displacer 18b, or the upper lid portion and the lower lid portion of the second displacer 18b may be fixed to the main body by any appropriate method such as fastening and welding, thereby accommodating the second regenerator material in the second displacer 18b.

The displacer assembly 18 forms an upper chamber 30, a first expansion chamber 32, and a second expansion chamber 34 inside the expander cylinder 16. To exchange heat with a desired object or medium to be cooled by the cryocooler 10, the expander 14 includes a first cooling stage 33 and a second cooling stage 35. The upper chamber 30 is formed between the upper lid portion of the first displacer 18a and an upper portion of the first cylinder 16a. The first expansion chamber 32 is formed between the lower lid portion of the first displacer 18a and the first cooling stage 33. The second expansion chamber 34 is formed between the lower lid portion of the second displacer 18b and the second cooling stage 35. The first cooling stage 33 is affixed to a lower portion of the first cylinder 16a to surround the first expansion chamber 32, and the second cooling stage 35 is affixed to a lower portion of the second cylinder 16b to surround the second expansion chamber 34. The first cooling stage 33 and the second cooling stage 35 are formed of, for example, pure copper (for example, oxygen-free copper or tough-pitch copper) or other high-thermal-conductivity metal.

The first regenerator 26 is connected to the upper chamber 30 through a working gas flow path 36a formed in the upper lid portion of the first displacer 18a, and is connected to the first expansion chamber 32 through a working gas flow path 36b formed in the lower lid portion of the first displacer 18a. The second regenerator 28 is connected to the first regenerator 26 through a working gas flow path 36c formed from the lower lid portion of the first displacer 18a to the upper lid portion of the second displacer 18b. In addition, the second regenerator 28 is connected to the second expansion chamber 34 through a working gas flow path 36d formed in the lower lid portion of the second displacer 18b.

A first seal 38a and a second seal 38b may be provided to guide the flow of the working gas between the first expansion chamber 32, the second expansion chamber 34, and the upper chamber 30 to the first regenerator 26 and the second regenerator 28 instead of a clearance between the expander cylinder 16 and the displacer assembly 18. The first seal 38a may be mounted on the upper lid portion of the first displacer 18a to be disposed between the first displacer 18a and the first cylinder 16a. The second seal 38b may be mounted on the upper lid portion of the second displacer 18b to be disposed between the second displacer 18b and the second cylinder 16b.

As shown in FIG. 2, the expander 14 includes an expander housing 20 that accommodates the pressure switching valve 40. The expander housing 20 is coupled to the expander cylinder 16, and accordingly a hermetic container that accommodates the pressure switching valve 40 and the displacer assembly 18 is configured. The expander housing 20 and the expander cylinder 16 are formed of, for example, a metal material such as stainless steel or other suitable high-strength material to withstand a pressure difference between an inside and an outside of the hermetic container.

As shown in FIG. 3, the pressure switching valve 40 includes a high-pressure valve 40a and a low-pressure valve 40b, and is configured to generate a periodic pressure fluctuation in the expander cylinder 16. A working gas discharge port of the compressor 12 is connected to the upper chamber 30 via the high-pressure valve 40a, and a working gas suction port of the compressor 12 is connected to the upper chamber 30 via the low-pressure valve 40b. The high-pressure valve 40a and the low-pressure valve 40b are configured to open and close selectively and alternately (that is, such that when one is open, the other is closed).

The pressure switching valve 40 may take a form of a rotary valve. That is, the pressure switching valve 40 may be configured such that the high-pressure valve 40a and the low-pressure valve 40b are alternately opened and closed by rotational sliding of a valve disk with respect to a stationary valve main body. In this case, an expander motor 42 may be connected to the pressure switching valve 40 to rotate the valve disk of the pressure switching valve 40. For example, the pressure switching valve 40 is disposed such that a valve rotation axis is coaxial with the rotation axis of the expander motor 42.

Alternatively, the high-pressure valve 40a and the low-pressure valve 40b each may be a valve that can be individually controlled, and in this case, the pressure switching valve 40 may not be connected to the expander motor 42.

The expander 14 includes an expander motor 42 and a motion conversion mechanism 43. The expander motor 42 is a drive source that drives the expander 14, and is, for example, an electric motor that is driven by the three-phase alternating current. The expander motor 42 is attached to the expander housing 20. The motion conversion mechanism 43 is accommodated in the expander housing 20 in the same manner as the pressure switching valve 40.

The expander motor 42 is connected to a displacer drive shaft 44, for example, via a motion conversion mechanism 43 such as a scotch yoke mechanism. The motion conversion mechanism 43 converts a rotating motion output by the expander motor 42 into linear reciprocating motion of the displacer drive shaft 44. The displacer drive shaft 44 extends from the motion conversion mechanism 43 into the upper chamber 30, and is fixed to the upper lid portion of the first displacer 18a. The rotation of the expander motor 42 is converted into the axial reciprocation of the displacer drive shaft 44 by the motion conversion mechanism 43, and the displacer assembly 18 linearly reciprocates in the axial direction in the expander cylinder 16.

In addition, the cryocooler 10 is provided with an expander inverter 45 that controls the operation frequency, that is, the rotation speed of the expander motor 42. Although the expander inverter 45 is mounted on the compressor 12 in this example, the present invention is not limited thereto and the expander inverter 45 may be mounted on the expander 14. The expander inverter 45 is configured to convert an alternating current input from the power source 46 to the expander inverter 45 into an alternating current having a frequency different from the input alternating current, and supply the converted alternating current to the expander motor 42. The operation frequency of the expander motor 42 may be controlled by the expander inverter 45 in a range of 30 Hz to 100 Hz or in a range of 40 Hz to 70 Hz.

In addition, a first temperature sensor 130a that measures the first cooling temperature and a second temperature sensor 130b that measures the second cooling temperature may be provided.

The first temperature sensor 130a may be disposed to measure the temperature of any portion cooled to the first cooling temperature in the superconducting magnet device 100. For example, as shown in FIG. 2, the first temperature sensor 130a may be attached to the first cooling stage 33. Alternatively, as shown in FIG. 1, the first temperature sensor 130a may be attached to a portion (for example, a high-temperature side end portion of the inner current lead 114d or a low-temperature side end portion of the outer current lead 114c) of the electric current introduction line 114 cooled to the first cooling temperature. The first temperature sensor 130a may be attached to the thermal shield 124.

The second temperature sensor 130b may be disposed to measure the temperature of any portion cooled to the second cooling temperature in the superconducting magnet device 100. For example, as shown in FIG. 2, the second temperature sensor 130b may be attached to the second cooling stage 35. Alternatively, as shown in FIG. 1, the second temperature sensor 130b may be attached to the superconducting coil 112 or the heat transfer member 126.

The first temperature sensor 130a and the second temperature sensor 130b each are communicably connected to the controller 140 by wired or wireless communication, and can transmit information indicating the measured temperature to the controller 140. A first temperature signal T1 indicating the first cooling temperature measured by the first temperature sensor 130a may be input from the first temperature sensor 130a to the controller 140. A second temperature signal T2 indicating the second cooling temperature measured by the second temperature sensor 130b may be input from the second temperature sensor 130b to the controller 140.

The state monitoring sensor 132 is configured to measure a state parameter related to the superconducting magnet device 100. The state parameter may be a state parameter related to the superconducting coil device 110 or a state parameter related to the cryogenic device 120. The state parameter related to the superconducting coil device 110 may be an excitation state parameter representing an excitation state of the superconducting coil device 110.

In this embodiment, the state monitoring sensor 132 may measure, as the excitation state parameter, a current flowing through the electric current introduction line 114 to the superconducting coil 112. That is, the state monitoring sensor 132 may be a current sensor that measures the excitation current supplied to the superconducting coil 112. As shown in FIG. 1, the state monitoring sensor 132 may be provided in the excitation power supply 116 to measure the excitation current to the superconducting coil 112. Alternatively, the state monitoring sensor 132 may be provided in the electric current introduction line 114 (for example, the external wiring line 114a) to measure the excitation current to the superconducting coil 112.

Since the intensity of the magnetic field generated by the superconducting coil 112 is generally linearly correlated with the excitation current to the superconducting coil 112, the state monitoring sensor 132 may measure, as the excitation state parameter, the magnetic field (for example, magnetic flux density) generated by the superconducting coil 112. Such a magnetic field sensor may be disposed at any location in a region where the superconducting coil 112 generates a magnetic field. For example, the magnetic field sensor may be disposed outside the vacuum chamber 122, such as being attached to an outer surface of the vacuum chamber 122. Alternatively, the magnetic field sensor may be disposed in the vacuum chamber 122, such as being attached to the superconducting coil 112 or installed in the vicinity thereof.

The state monitoring sensor 132 is communicably connected to the controller 140 by wired or wireless communication, and can transmit information indicating the measured state parameter to the controller 140. A state signal S indicating the state parameter measured by the state monitoring sensor 132 may be input from the state monitoring sensor 132 to the controller 140.

The superconducting coil device 110 is operable in a plurality of operation modes. The plurality of operation modes differ from each other in the excitation state of the superconducting coil device 110. The plurality of operation modes may include four operation modes of a zero magnetic field mode, an excitation sweep mode, a steady-state excitation mode, and a de-excitation sweep mode.

The zero magnetic field mode refers to a stopped state of the superconducting coil device 110, that is, a state in which the excitation current is not supplied to the superconducting coil 112. Therefore, in the zero magnetic field mode, the superconducting coil 112 does not generate a magnetic field.

The excitation sweep mode is used in a case of starting the superconducting magnet device 100. In the excitation sweep mode, the excitation current is supplied from the excitation power supply 116 to the superconducting coil 112 through the electric current introduction line 114. Therefore, the superconducting coil 112 generates a magnetic field corresponding to the excitation current. The excitation power supply 116 may increase the excitation current at a predetermined current increase rate (for example, a constant current increase rate) from zero to a target current value. The target current value may be a rated current value of the superconducting coil 112.

The steady-state excitation mode refers to an operation state of the superconducting coil device 110, that is, a state in which the excitation current to the superconducting coil 112 is maintained at the target current value. In the steady-state excitation mode, the excitation power supply 116 may maintain the excitation current at the rated current value.

The de-excitation sweep mode is used in a case of stopping the operation of the superconducting magnet device 100. In the de-excitation sweep mode, the excitation power supply 116 may decrease the excitation current of the superconducting coil 112 at a predetermined current decrease rate (for example, a constant current decrease rate) from the target current value to zero.

The controller 140 is configured to operate the superconducting coil device 110 in a selected operation mode among the plurality of operation modes. The controller 140 may receive an input representing an operation mode to be executed and select the operation mode from the plurality of operation modes. Such an input may be an input from a user of the superconducting magnet device 100 to the controller 140, or may be an input from a higher-level system including the superconducting magnet device 100 to the controller 140. Alternatively, the controller 140 may autonomously select the operation mode to be executed, for example, based on the state parameter related to the superconducting magnet device 100. The controller 140 may be configured to control the excitation power supply 116 to operate the superconducting coil device 110 in the selected operation mode.

In addition, the controller 140 is configured to provide temperature regulation control of the superconducting magnet device 100. Therefore, the controller 140 is configured to determine an operating parameter of the cryocooler 10 based on a comparison of a cooling temperature (a measured temperature from the temperature sensor 130, for example, the first temperature sensor 130a or the second temperature sensor 130b) of the superconducting coil device 110 or the cryocooler 10 with a temperature target value, and to operate the cryocooler 10 using the determined operating parameter.

For example, the controller 140 may be configured to determine a temperature error based on a comparison of the measured temperature from the temperature sensor 130 with the temperature target value, and to determine the operating parameter of the cryocooler 10 based on the temperature error. The controller 140 may include a feedback-control system that determines the operating parameter of the cryocooler 10 to reduce or minimize the temperature error. Since the cryocooler 10 can output a higher cooling capacity as the operating parameter is larger, the operating parameter to be determined is larger as the temperature error is larger, and the reverse is also true.

The temperature target value may be constant during the operation of the superconducting magnet device 100. Alternatively, the temperature target value may be changed during the operation of the superconducting magnet device 100. For example, the controller 140 may set different temperature target values according to the selected operation mode. In this manner, it is possible to effectively deal with a change in the amount of heat generated by the superconducting coil 112 according to the operation mode.

For example, in a case where the excitation current is fluctuating (for example, in the excitation sweep mode or the de-excitation sweep mode), the amount of heat generated by the superconducting coil 112 may increase as compared with a case where the excitation current is maintained (for example, in the zero magnetic field mode or the steady-state excitation mode). One of the reasons is that, for example, in a case of excitation or de-excitation, the superconducting coil 112 may generate heat due to an alternating current loss, which may cause a temperature rise. The alternating current loss is caused by a time rate of change of the excitation current to the superconducting coil 112 (in other words, the magnetic field generated by the superconducting coil 112). In addition, in a case of excitation or de-excitation, a stick-slip phenomenon may occur due to deformation of the superconducting coil 112. Such a mechanical disturbance may cause momentary heat generation to occur locally in the superconducting coil 112.

Therefore, the controller 140 may set the temperature target value used in the operation mode (for example, the excitation sweep mode or the de-excitation sweep mode) in which the excitation current fluctuates to be lower than the temperature target value used in the operation mode (for example, the zero magnetic field mode or the steady-state excitation mode) in which the excitation current is maintained. In this manner, it is possible to suppress the temperature rise of the superconducting coil 112 in the operation mode in which the excitation current fluctuates and to reduce the risk of quenching (loss of superconductivity).

The operating parameter of the cryocooler 10 may be an operation frequency of the compressor motor 24 or an operation frequency of the expander motor 42. The controller 140 may be configured to generate a compressor command signal B1 indicating a command value of the operation frequency of the compressor motor 24 based on a comparison of the measured temperature from the temperature sensor 130 with the temperature target value, and to output the compressor command signal B1 to the compressor inverter 25. The compressor inverter 25 can drive the compressor motor 24 at the operation frequency of the command value in response to the compressor command signal B1. In addition, the controller 140 may be configured to generate an expander command signal B2 indicating a command value of the operation frequency of the expander motor 42 based on a comparison of the measured temperature from the temperature sensor 130 with the temperature target value, and to output the expander command signal B2 to the expander inverter 45. The expander inverter 45 can drive the expander motor 42 at the operation frequency of the command value in response to the expander command signal B2.

Details will be described later, but the cryocooler monitor 142 is configured to acquire a value of the operating parameter of the cryocooler 10 determined by the controller 140 in a case where the superconducting coil device 110 is operating in the selected operation mode, and to diagnose the cryocooler 10 based on the acquired value of the operating parameter.

The internal configuration of the control device 138 (for example, the controller 140 or the cryocooler monitor 142) is realized by an element or a circuit including a CPU and a memory of a computer as a hardware configuration and is realized by a computer program as a software configuration. However, in the drawing, the internal configuration is appropriately shown as functional blocks realized by cooperation of hardware and software. It is clear for those skilled in the art that such a functional block can be realized in various manners through combination between hardware and software.

For example, the control device 138 (for example, the controller 140 and the cryocooler monitor 142) can be implemented by a combination of a processor (hardware), such as a central processing unit (CPU) or a microcontroller, and a software program executed by the processor (hardware). Such a hardware processor may be configured by a programmable logic device such as a field programmable gate array (FPGA), or may be a control circuit such as a programmable logic controller (PLC). The software program may be a computer program for causing the control device 138 to execute the control of the superconducting magnet device 100 or the diagnosis of the cryocooler 10.

As shown in FIGS. 1 and 2, the control device 138 may be disposed separately from the excitation power supply 116 and the cryocooler 10 of the superconducting magnet device 100. Alternatively, the control device 138 may be incorporated into the excitation power supply 116. Alternatively, the control device 138 may be mounted on a component (for example, the compressor 12 or the expander 14) of the cryocooler 10. Alternatively, the control device 138 may be disposed remotely from the superconducting magnet device 100 and the cryocooler 10 and may be communicably connected to these.

In addition, in the example shown in the drawing, the cryocooler monitor 142 is incorporated into the control device 138 (for example, the controller 140), but other dispositions are also possible. For example, the cryocooler monitor 142 may be disposed remotely from the controller 140 and may be communicably connected to the controller 140 via the Internet or another appropriate communication network.

With the above configuration, in a case where the compressor 12 and the expander motor 42 are operated, the cryocooler 10 generates periodic volume fluctuations in the first expansion chamber 32 and the second expansion chamber 34 and pressure fluctuations of the working gas synchronized with the periodic volume fluctuations. Typically, in the intake process, as the low-pressure valve 40b is closed and the high-pressure valve 40a is opened, the high-pressure working gas flows from the compressor 12 into the upper chamber 30 through the high-pressure valve 40a, is supplied to first expansion chamber 32 through the first regenerator 26, and is supplied to the second expansion chamber 34 through the second regenerator 28. In this manner, the first expansion chamber 32 and the second expansion chamber 34 are pressurized from a low pressure to a high pressure. In this case, the displacer assembly 18 is moved upward from the bottom dead center to the top dead center, and the volumes of the first expansion chamber 32 and the second expansion chamber 34 are increased. When the high pressure valve 40a is closed, the intake process ends.

In the exhaust process, as the high-pressure valve 40a is closed and the low-pressure valve 40b is opened, the high-pressure first expansion chamber 32 and second expansion chamber 34 are opened to the low-pressure working gas suction port of the compressor 12, whereby the working gas expands in the first expansion chamber 32 and the second expansion chamber 34. As a result, the low-pressure working gas is discharged from the first expansion chamber 32 and the second expansion chamber 34 to the upper chamber 30 through the first regenerator 26 and the second regenerator 28. In this case, the displacer assembly 18 is moved downward from the top dead center to the bottom dead center, and the volumes of the first expansion chamber 32 and the second expansion chamber 34 are decreased. The working gas is collected from the expander 14 to the compressor 12 through the low-pressure valve 40b. When the low-pressure valve 40b is closed, the exhaust process ends.

In this manner, for example, a refrigeration cycle such as a GM cycle is configured, and the first cooling stage 33 and the second cooling stage 35 are cooled to desired cryogenic temperatures. The first cooling stage 33 may be cooled to a first cooling temperature in a range of, for example, about 30K to about 70K. A portion (for example, a low-temperature side end portion of the outer current lead 114c and a high-temperature side end portion of the inner current lead 114d) of the electric current introduction line 114 thermally coupled to the first cooling stage 33 and the thermal shield 124 are also cooled to the first cooling temperature. The second cooling stage 35 can be cooled to a second cooling temperature (for example, about 1 K to about 4 K) lower than the first cooling temperature. The superconducting coil 112 is cooled to the second cooling temperature by the second cooling stage 35.

In this way, the cryocooler 10 can cool the superconducting coil 112 to a temperature equal to or lower than the critical temperature, and the superconducting magnet device 100 can operate the superconducting coil device 110 in the selected operation mode from among the plurality of operation modes.

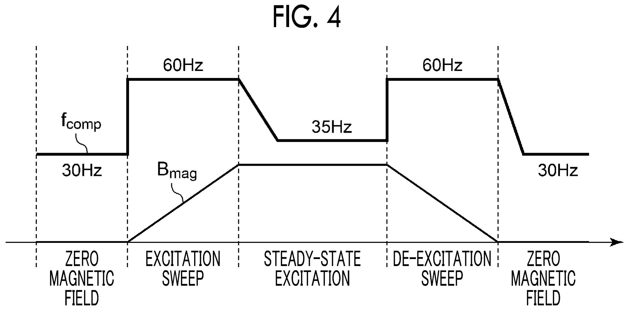

FIG. 4 is a graph schematically showing an exemplary operation of the superconducting magnet device 100 according to the embodiment. FIG. 4 shows a state parameter of the superconducting magnet device 100 and an operating parameter of the cryocooler 10 when the superconducting magnet device 100 is normally operated. In an upper part of FIG. 4, a time change of an operation frequency f_{comp} of the compressor 12 is shown as an example of the operating parameter of the cryocooler 10. In a lower part of FIG. 4, a time change of a magnetic field B_{mag} generated by the superconducting coil 112 is shown as an example of the state parameter of the superconducting magnet device 100.

In the operation of the superconducting magnet device 100 shown as an example, the operation mode is switched in the order of the zero magnetic field mode, the excitation sweep mode, the steady-state excitation mode, the de-excitation sweep mode, and the zero magnetic field mode as time elapses. Therefore, as shown in the lower part of FIG. 4, the magnetic field B_{mag} is zero in the zero magnetic field mode, increases from zero to a certain magnitude in the excitation sweep mode, is maintained at the magnitude in the steady-state excitation mode, and decreases to zero in the de-excitation sweep mode.

The temperature target value of the cooling temperature of the superconducting coil 112 may be set for each operation mode. For example, as described above, the temperature target value in the excitation sweep mode and the de-excitation sweep mode may be a smaller value than the temperature target value in the zero magnetic field mode and the steady-state excitation mode. Therefore, the operation frequency f_{comp} of the compressor 12 takes a relatively large value (for example, about 60 Hz) in the excitation sweep mode and the de-excitation sweep mode, and takes a relatively small value (for example, about 30 Hz in the zero magnetic field mode and about 35 Hz in the steady-state excitation mode) in the zero magnetic field mode and the steady-state excitation mode. Similarly, the operation frequency of the expander 14 also increases and decreases in the same profile as the operation frequency f_{comp} of the compressor 12.

Alternatively, the temperature target value may be set to a constant value regardless of the operation mode. As described above, in a case where the excitation current is fluctuating (for example, in the excitation sweep mode or the de-excitation sweep mode), the amount of heat generated by the superconducting coil 112 may increase as compared with a case where the excitation current is maintained (for example, in the zero magnetic field mode or the steady-state excitation mode). Therefore, even in this case, as shown in FIG. 4, the operating parameter of the cryocooler 10 can take a relatively large value in the excitation sweep mode and the de-excitation sweep mode, and can take a relatively small value in the zero magnetic field mode and the steady-state excitation mode.

As described above, the operating parameter of the cryocooler 10 changes to a different value when the operation mode of the superconducting coil device 110 is changed, but is maintained at a specific value corresponding to the operation mode during the operation in the same operation mode. It is noted that the operating parameter may change significantly due to a transient response immediately after switching from one operation mode to another operation mode, but such a transient response is omitted in FIG. 4 for simplicity.

As described at the beginning of the present specification, a method for identifying the performance reduction of the cryocooler over time by monitoring the cooling temperature of the cryocooler is known. In this method, the increase in the cooling temperature is regarded as the reduction of the cooling performance of the cryocooler. This can function well in the inverter-uncontrolled cryocooler in the related art. This is because, in the inverter-non-equipped cryocooler, since the motor is driven at a constant operation frequency, the reduction of the cooling performance directly leads to the increase in the cooling temperature.

The present inventor has found that this diagnostic method based on the cooling temperature is not necessarily effective for the inverter-equipped cryocooler (for example, the cryocooler 10). This is because, in the cryocooler 10, even in a case where the cooling performance is reduced to some extent, the reduction is compensated for by an increase in the operating parameter under the temperature regulation control, and the cooling temperature is continuously maintained at the temperature target value. The cooling temperature deviates significantly from the temperature target value only in a case where the deterioration or the failure of the cryocooler 10 occurs to the extent that the temperature regulation control cannot function. That is, in the inverter-equipped cryocooler, it is difficult to identify the failure or a precursor of the failure by monitoring the cooling temperature and to proactively deal with the failure, and it is difficult to minimize the influence on the operation of the superconducting magnet device.

In the present embodiment, as described above, the controller 140 is configured to determine the operating parameter of the cryocooler 10 based on the comparison of the cooling temperature of the superconducting coil device 110 or the cryocooler 10 with the temperature target value, and to operate the cryocooler 10 by using the determined operating parameter. Therefore, the performance reduction of the cryocooler 10 causes the increase in the operating parameter of the cryocooler 10.

Therefore, in the present embodiment, the cryocooler monitor 142 is configured to acquire the value of the operating parameter of the cryocooler 10 determined by the controller 140 in a case where the superconducting coil device 110 is operating in the selected operation mode, and to diagnose the cryocooler 10 based on the acquired value of the operating parameter.

As described with reference to FIG. 4, the operating parameter of the cryocooler 10 is maintained at a specific value corresponding to the operation mode while the superconducting coil device 110 is normally operated in the same operation mode. Therefore, in a case where the superconducting coil device 110 is operating in a certain operation mode and the operating parameter is increased from the reference value of the operating parameter for each operation mode, it can be determined that the cooling performance of the cryocooler 10 is reduced as compared with the normal state.

As described above, the cryocooler 10 can be diagnosed based on the value of the operating parameter of the cryocooler 10 in the selected operation mode of the superconducting coil device 110. By detecting the performance reduction of the cryocooler 10 and performing the maintenance (for example, repair or replacement) of the cryocooler 10 in a preventive manner, it is possible to prevent the sudden failure of the cryocooler 10 and minimize the influence on the operation of the superconducting magnet device 100. An exemplary diagnostic method according to the embodiment will be described below.

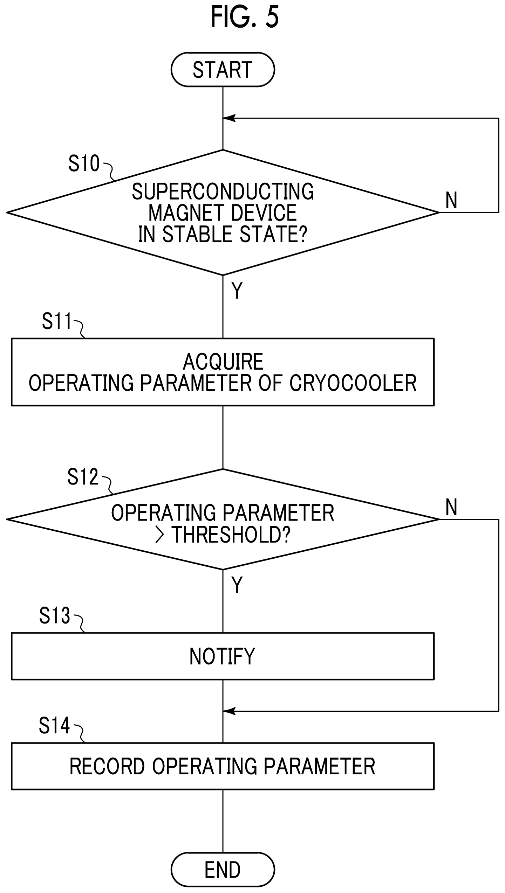

FIG. 5 is a flowchart showing an example of a diagnostic method for the cryocooler 10 according to the embodiment. The cryocooler monitor 142 may execute the diagnostic processing in response to the switching of the operation mode of the superconducting coil device 110. The cryocooler monitor 142 may acquire operation mode information representing the selected operation mode among the plurality of operation modes of the superconducting coil device 110, and may detect the switching of the operation mode from the operation mode information. The controller 140 generates the operation mode information, and the cryocooler monitor 142 may acquire the operation mode information from the controller 140. Alternatively, the cryocooler monitor 142 may acquire a measured value of the state parameter (for example, an excitation state parameter representing the excitation state of the superconducting coil device 110) of the superconducting magnet device 100 from the state monitoring sensor 132, and may detect the switching of the operation mode based on the measured value.

Alternatively, the cryocooler monitor 142 may execute the diagnostic processing at any time (for example, periodically) regardless of the change in the operation mode.

As shown in FIG. 5, in a case where the diagnostic processing is started, the cryocooler monitor 142 determines whether or not the superconducting magnet device 100 is in a stable state (S10). The cryocooler monitor 142 may determine whether or not the superconducting magnet device 100 is in the stable state based on the state parameter of the superconducting magnet device 100.

For example, the state parameter may be an elapsed time from the switching of the operation mode. This is because the transient state associated with switching of the operation mode converges as time elapses. Therefore, the cryocooler monitor 142 may determine whether or not a predetermined time has elapsed from the start of the selected operation mode. In a case where the predetermined time has not elapsed, the cryocooler monitor 142 determines that the superconducting magnet device 100 is not in the stable state (that is, is in the transient state). In a case where the predetermined time has elapsed, the cryocooler monitor 142 determines that the superconducting magnet device 100 is in the stable state. The predetermined time for the determination can be appropriately set based on the experiential knowledge of the designer or the experiment, the simulation, or the like by the designer. The predetermined time may be set to a different value for each operation mode.

The state parameter may be the cooling temperature of the superconducting coil device 110 (for example, the superconducting coil 112 or the thermal shield 124) or the cryocooler 10 (for example, the second cooling stage 35 or the first cooling stage 33). The cryocooler monitor 142 may determine whether or not the cooling temperature is equal to or lower than a temperature threshold value. In a case where the cooling temperature exceeds the temperature threshold value, the cryocooler monitor 142 determines that the superconducting magnet device 100 is not in the stable state. In a case where the cooling temperature is equal to or lower than the temperature threshold value, the cryocooler monitor 142 determines that the superconducting magnet device 100 is in the stable state. It is possible to set the temperature threshold value as appropriate based on empirical knowledge of a designer or experiments and simulations by the designer. The temperature threshold value may be set to a different value for each operation mode.

The state parameter may be a time rate of change of the cooling temperature of the superconducting coil device 110 or the cryocooler 10. The cryocooler monitor 142 may determine whether or not the time rate of change of the cooling temperature is equal to or less than a threshold value. In a case where the time rate of change of the cooling temperature exceeds the threshold value, the cryocooler monitor 142 determines that the superconducting magnet device 100 is not in the stable state. In a case where the time rate of change of the cooling temperature is equal to or less than the threshold value, the cryocooler monitor 142 determines that the superconducting magnet device 100 is in the stable state. The threshold value of the time rate of change can be appropriately set based on the experiential knowledge of the designer or the experiment, the simulation, or the like by the designer. The temperature threshold value may be set to a different value for each operation mode.

The state parameter may be a time rate of change of the operating parameter of the cryocooler 10. The cryocooler monitor 142 may determine whether or not the time rate of change of the operating parameter is equal to or less than a threshold value. In a case where the time rate of change of the operating parameter exceeds the threshold value, the cryocooler monitor 142 determines that the superconducting magnet device 100 is not in the stable state. In a case where the time rate of change of the operating parameter is equal to or less than the threshold value, the cryocooler monitor 142 determines that the superconducting magnet device 100 is in the stable state. The threshold value of the time rate of change can be appropriately set based on the experiential knowledge of the designer or the experiment, the simulation, or the like by the designer. The temperature threshold value may be set to a different value for each operation mode.

In a case where the superconducting magnet device 100 is not in the stable state (N in S10), the cryocooler monitor 142 determines whether or not the superconducting magnet device 100 is in the stable state again at the next timing without diagnosing the cryocooler 10 (S10). In this way, the cryocooler monitor 142 waits until the superconducting magnet device 100 is in the stable state.

In a case where the superconducting magnet device 100 is in the stable state (Y in S10), the cryocooler monitor 142 acquires the value of the operating parameter (for example, the operation frequency of the compressor 12) of the cryocooler 10 determined by the controller 140 (S11). Therefore, the cryocooler monitor 142 can acquire the current value of the operating parameter of the cryocooler 10 when the superconducting coil device 110 is operating in the selected operation mode and the superconducting magnet device 100 is in the stable state. As a result, it is possible to avoid the diagnosis in the transient state due to the switching of the operation mode and to reduce the risk of erroneously determining the temporary increase in the operating parameter in the transient state as the reduction of the cooling performance.

Subsequently, the cryocooler monitor 142 diagnoses the cryocooler 10 based on the comparison of the acquired value of the operating parameter with the threshold value of the operating parameter (S12). In the comparison, the cryocooler monitor 142 determines the threshold value of the operating parameter based on the recorded value of the operating parameter in the selected operation mode. The recorded value may be a previous value of the operating parameter acquired in a case of the previous diagnosis in the same operation mode as described below. The previous value of the operating parameter may be used as the threshold value. Alternatively, a value obtained by adding a predetermined margin to the previous value of the operating parameter may be used as the threshold value. The threshold value can be appropriately set based on the experiential knowledge of the designer or the experiment, the simulation, or the like by the designer.

The cryocooler monitor 142 may determine whether or not the acquired value of the operating parameter exceeds the threshold value. In a case where the acquired value of the operating parameter exceeds the threshold value (Y in S12), the cryocooler monitor 142 notifies that the cooling performance of the cryocooler 10 is reduced (S13). The cryocooler monitor 142 may notify or warn that the cooling performance of the cryocooler 10 is reduced by a visual, auditory, or any other notification means.

In a case where the acquired value of the operating parameter is equal to or less than the threshold value (N in S12), the cooling performance of the cryocooler 10 is regarded as being within the normal range. Therefore, the cryocooler monitor 142 does not notify that the cooling performance of the cryocooler 10 is reduced. Alternatively, the cryocooler monitor 142 may notify that the cooling performance of the cryocooler 10 is within the normal range.

The cryocooler monitor 142 records the acquired value of the operating parameter (S14). The recorded value of the operating parameter is used to determine the operating parameter threshold value used for the next diagnosis in the same operation mode as described above. In this way, the present diagnostic processing ends.

The operating parameter threshold value can be determined by other methods. For example, the cryocooler monitor 142 may be configured to determine the operating parameter threshold value by selecting any one of a plurality of default values according to the selected operation mode of the superconducting coil device 110. In other words, the threshold value of the operating parameter may be determined as the default value for each of the plurality of operation modes, or the operating parameter threshold value corresponding to the selected operation mode may be used.

In the embodiment described above, the diagnosis of the cryocooler 10 is based on the comparison of the acquired value of the operating parameter with the threshold value of the operating parameter, but other methods are also possible. The diagnosis of the cryocooler 10 may be based on the history of the operating parameter for the selected operation mode of the superconducting coil device 110.

Therefore, the cryocooler monitor 142 is configured to update the history of the operating parameter for the selected operation mode of the superconducting coil device 110 based on the acquired value of the operating parameter, and to diagnose the cryocooler 10 based on the updated history. The cryocooler monitor 142 may determine whether or not the updated history of the cryocooler 10 satisfies a predetermined condition instead of S12 in FIG. 5. In a case where the condition is satisfied, the cryocooler monitor 142 may notify that the cooling performance of the cryocooler 10 is reduced (S13 in FIG. 5). In a case where the condition is not satisfied, the cooling performance of the cryocooler 10 may be regarded as being within the normal range.

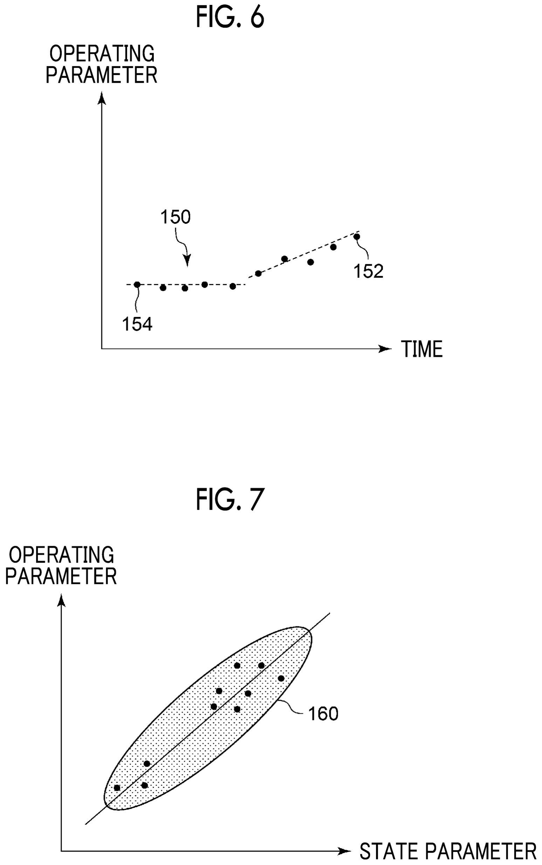

FIG. 6 is a graph schematically showing a history 150 of the operating parameter of the cryocooler 10 used for the diagnosis of the cryocooler 10 according to the embodiment. A vertical axis of FIG. 6 represents the operating parameter of the cryocooler 10, and a horizontal axis represents time. In FIG. 6, the operating parameter of the cryocooler 10 for the same operation mode among the plurality of operation modes of the superconducting coil device 110 is plotted. That is, FIG. 6 shows time-series data of the operating parameter of the cryocooler 10 acquired over time for the same operation mode.

The cryocooler monitor 142 acquires the value (for example, a plot 152 in FIG. 6) of the operating parameter of the cryocooler 10 determined by the controller 140 (S11 in FIG. 5). The cryocooler monitor 142 may update the history 150 of the operating parameter by adding the acquired value of the operating parameter to the history 150.

The condition for the diagnosis may be, for example, that an increase amount of the acquired value (plot 152) of the operating parameter with respect to an initial value 154 of the operating parameter in the history 150 exceeds the threshold value. In a case where the increase amount exceeds the threshold value, the cryocooler monitor 142 may notify that the cooling performance of the cryocooler 10 is reduced (S13 in FIG. 5). In a case where the increase amount is equal to or less than the threshold value, the cooling performance of the cryocooler 10 may be regarded as being within the normal range. Alternatively, the condition for the diagnosis may be that the acquired value of the operating parameter is continuously (for example, over a plurality of times of acquisition of the operating parameter) increasing. In a case where the value of the operating parameter is continuously increasing, the cryocooler monitor 142 may notify that the cooling performance of the cryocooler 10 is reduced. The condition for the diagnosis can be appropriately set based on the experiential knowledge of the designer or the experiment, the simulation, or the like by the designer.

As another example of the diagnostic method, the cryocooler monitor 142 may be configured to diagnose the cryocooler 10 based on the statistical analysis of the operation history data of the superconducting magnet device 100. The operation history data of the superconducting magnet device 100 may include at least one state parameter related to the operating parameter of the cryocooler 10 and the superconducting magnet device 100. The state parameter related to the superconducting magnet device 100 may include an excitation state parameter representing an excitation state of the superconducting coil device 100. The state parameter related to the superconducting magnet device 100 may be the cooling temperature of the superconducting coil device 110 or the cryocooler 10.

FIG. 7 is a graph schematically showing the statistical analysis of the operation history data of the superconducting magnet device 100 used for the diagnosis of the cryocooler 10 according to the embodiment. A vertical axis of FIG. 7 represents the operating parameter of the cryocooler 10, and a horizontal axis represents the state parameter related to the superconducting magnet device 100. Here, for simplicity, the statistical analysis of the operation history data plotted on a plane consisting of one operating parameter and one state parameter is schematically shown, but it will be understood that the statistical analysis of the operation history data in a multidimensional space consisting of a plurality of operating parameters and a plurality of state parameters is also possible.

By performing multivariate analysis such as cluster analysis on the operation history data of the superconducting magnet device 100, a healthy region 160 can be set in a multidimensional space in which the operating parameter and the state parameter are variables. The healthy region 160 represents a region in the multidimensional space indicating that the cryocooler 10 is normal in a case where the combination of the acquired operating parameter and the state parameter is included in the region. Such statistical analysis may be performed by using machine learning.

Therefore, the cryocooler monitor 142 may determine whether or not the combination of the operating parameter and the state parameter acquired from the controller 140 is included in the healthy region 160. In a case where the combination is included in the healthy region 160, the cryocooler monitor 142 may determine that the cooling performance of the cryocooler 10 is within the normal range. In a case where the combination of the acquired operating parameter and the state parameter deviates from the healthy region 160, the cryocooler monitor 142 may notify that the cooling performance of the cryocooler 10 is reduced.

Alternatively, the statistical analysis of the operation history data of the superconducting magnet device 100 may be regression analysis. The cryocooler monitor 142 may diagnose the cryocooler 10 based on the comparison of the combination of the acquired operating parameter and the state parameter with a regression equation obtained by the statistical analysis.

Alternatively, the cryocooler monitor 142 may include a diagnosis algorithm based on machine learning such as deep learning, and the diagnosis algorithm may be configured to output a diagnosis result for an index (for example, the cooling capacity of the cryocooler 10) representing the health of the cryocooler 10 with the operation history data of the superconducting magnet device 100 as an input.

The present invention has been described hereinbefore based on the examples. The present invention is not limited to the above-described embodiment, and various design changes are possible, and it will be understood by those skilled in the art that various modification examples are possible and such modification examples also fall within the scope of the present invention. Various features described in relation to a certain embodiment are also applicable to other embodiments. A new embodiment resulting from combination will have the effects of each of the embodiments that are combined.

In the above-described embodiment, a case where the cryocooler 10 is a GM cryocooler has been described as an example. However, the present invention is not limited thereto. The cryocooler monitor 142 according to the embodiment may be applied to another form of the cryocooler that can be used for cooling the superconducting magnet device 100, such as a pulse tube cryocooler, a GM-JT cryocooler, or a Stirling cryocooler, in a certain embodiment.

Although the present invention has been described using specific words and phrases based on the embodiment, the embodiment merely shows one aspect of the principle and application of the present invention, and many modification examples and changes in disposition are allowed without departing from the concept of the present invention specified in the claim.

### Brief Description of the Reference Symbols

- 10: cryocooler
- 12: compressor
- 14: expander
- 24: compressor motor
- 42: expander motor
- 100: superconducting magnet device
- 112: superconducting coil
- 138: control device
- 140: controller
- 142: cryocooler monitor

## Claims

1. A superconducting magnet device (100) comprising:
a superconducting coil device (110) that is operable in a plurality of operation modes;
a cryocooler (10) that cools the superconducting coil device (110);
a controller (140) that is configured to operate the superconducting coil device (110) in a selected operation mode among the plurality of operation modes and is configured to determine an operating parameter of the cryocooler (10) based on a comparison of a cooling temperature of the superconducting coil device (110) or the cryocooler (10) with a temperature target value and to operate the cryocooler (10) by using the determined operating parameter; and
a cryocooler monitor (142) that is configured to acquire a value of the determined operating parameter when the superconducting coil device (110) is operating in the selected operation mode, and to diagnose the cryocooler (10) based on the acquired value of the operating parameter.

2. The superconducting magnet device (100) according to claim 1,
wherein the cryocooler monitor (142) is configured to diagnose the cryocooler (10) based on a comparison of the acquired value of the operating parameter with a threshold value of the operating parameter.

3. The superconducting magnet device (100) according to claim 2,
wherein the cryocooler monitor (142) is configured to determine the threshold value of the operating parameter based on a recorded value of the operating parameter of the superconducting coil device (110) in the selected operation mode.

4. The superconducting magnet device (100) according to claim 2,
wherein the cryocooler monitor (142) is configured to determine the threshold value of the operating parameter by selecting any one of a plurality of default values according to the selected operation mode of the superconducting coil device (110).

5. The superconducting magnet device (100) according to claim 1,
wherein the cryocooler monitor (142) is configured to update a history of the operating parameter for the selected operation mode of the superconducting coil device (110) based on the acquired value of the operating parameter, and is configured to diagnose the cryocooler (10) based on the updated history.

6. The superconducting magnet device (100) according to any one of claims 2 to 5,
wherein the cryocooler monitor (142) is configured to acquire the value of the determined operating parameter when the superconducting coil device (110) is operating in the selected operation mode and the superconducting magnet device (100) is in a stable state.

7. The superconducting magnet device (100) according to claim 1,
wherein the cryocooler monitor (142) is configured to diagnose the cryocooler (10) based on statistical analysis of operation history data of the superconducting magnet device (100), the operation history data including the operating parameter and at least one state parameter related to the superconducting magnet device (100).

8. The superconducting magnet device (100) according to claim 1,
wherein the cryocooler (10) includes a compressor (12) including a compressor motor (24) and an expander (14) including an expander motor (42),
the controller (140) is configured to determine, as the operating parameter of the cryocooler (10), an operation frequency of at least one of the compressor motor (24) and the expander motor (42) based on the comparison of the cooling temperature with the temperature target value and to operate the cryocooler (10) using the determined operation frequency, and
the cryocooler monitor (142) is configured to acquire a value of the determined operation frequency when the superconducting coil device (110) is operating in the selected operation mode and to diagnose the cryocooler (10) based on the acquired value of the operation frequency.

9. The superconducting magnet device (100) according to claim 1,
wherein the plurality of operation modes differ from each other in terms of an excitation state of the superconducting coil device (110).

10. A control device (138) of a superconducting magnet device (100), the superconducting magnet device (100) including a superconducting coil device (110) that is operable in a plurality of operation modes and a cryocooler (10) that cools the superconducting coil device (110), the control device comprising:
a controller (140) that is configured to operate the superconducting coil device (110) in a selected operation mode among the plurality of operation modes and is configured to determine an operating parameter of the cryocooler (10) based on a comparison of a cooling temperature of the superconducting coil device (110) or the cryocooler (10) with a temperature target value and to operate the cryocooler (10) by using the determined operating parameter; and
a cryocooler monitor (142) that is configured to acquire a value of the determined operating parameter when the superconducting coil device (110) is operating in the selected operation mode, and to diagnose the cryocooler (10) based on the acquired value of the operating parameter.
